(19)

Europäisches
Patentamt

European
Patent Office

Office européen
des brevets

(11)  **EP 4 687 289 A1**

(12)  **EUROPEAN PATENT APPLICATION**

(43) Date of publication:
   **04.02.2026 Bulletin 2026/06**

(21) Application number: **25190661.6**

(22) Date of filing: **21.07.2025**

(51) International Patent Classification (IPC):
   *H03K 3/037* (2006.01)    *H03K 19/094* (2006.01)
   *G06F 7/58* (2006.01)

(52) Cooperative Patent Classification (CPC):
   **H03K 3/037; H03K 19/094**

(84) Designated Contracting States:
   **AL AT BE BG CH CY CZ DE DK EE ES FI FR GB
   GR HR HU IE IS IT LI LT LU LV MC ME MK MT NL
   NO PL PT RO RS SE SI SK SM TR**
   Designated Extension States:
   **BA**
   Designated Validation States:
   **GE KH LA MA MD TN**

(30) Priority:  **31.07.2024  US 202463677528 P**

(71) Applicant: **Extropic Corp.
   Austin TX 78757 (US)**

(72) Inventors:
   • **MASSARELLI, Geremia**
    **Cambridge, 02140 (US)**
   • **FREITAS, Jose Nahuel**
    **Cambridge, 02139 (US)**
   • **CHAMBERLAND, Christopher Abraham**
    **Austin, 78748 (US)**
   • **VERDON-AKZAM, Guillaume**
    **San Francisco, 94133 (US)**

(74) Representative: **Piotrowicz, Pawel Jan Andrzej et
   al
   Venner Shipley LLP
   406 Cambridge Science Park
   Milton Road
   Cambridge CB4 0WW (GB)**

(54)  **CIRCUITS FOR PROVIDING COMBINATIONS OF INPUTS ASSOCIATED WITH BISTABLE STATES**

(57)   An apparatus comprises: a metastable circuit module including more than two output nodes, wherein the more than two output nodes are associated with a bistable state that varies over time between a first stable and second stable voltage, where a fraction of time that the bistable state spends at the first stable voltage is associated with a probability; a plurality of noise circuits, where each noise circuit is configured to produce a voltage distribution; and a mixer circuit comprising more than two gate circuits, where each gate circuit is connected to a respective output node of the metastable circuit module and to a respective noise circuit; wherein the mixer circuit is configured to produce a voltage distribution that is based at least in part on each probability associated with the metastable circuit module and each voltage distribution associated with a respective noise circuit of the plurality of noise circuits.

FIG. 5C

**Description**

CROSS-REFERENCE TO RELATED APPLICATION(S)

This application claims priority to and the benefit of U.S. Provisional Application Serial No. 63/677,528, entitled "CIRCUITS FOR PROVIDING COMBINATIONS OF INPUTS ASSOCIATED WITH BISTABLE STATES," filed July 31, 2024.

TECHNICAL FIELD

This disclosure relates to circuits for providing combinations of inputs associated with bistable states.

BACKGROUND

Integrated circuits (ICs) comprising interconnected components including resistors, transistors, and capacitors can be used to build electronic devices capable of performing complex operations. Some IC devices can be utilized to build electronic devices that are capable of performing computations. Compact designs coupled with advances in mass production capabilities and technologies have contributed to the widespread adoption of ICs. Current implementations of IC devices utilize metal-oxide-semiconductor (MOS) integrated circuits that are built on chip platforms typically comprising silicon. Some IC devices can be built with complementary metal-oxide-semiconductors (CMOS) comprising semiconductors doped with elements to modify their associated physical properties.

SUMMARY

In one aspect, in general, an apparatus comprises: a plurality of circuit modules, each circuit module of the plurality of circuit modules having a first input node, a second input node, a first output node, and a second output node, and comprising a metastable circuit configured to receive a bias voltage from the first input node and produce a bistable state based at least in part on the bias voltage; a first logical circuit configured to receive a signal based at least in part on the bistable state and a voltage from the second input node and output a logical combination of the signal based at least in part on the bistable state and the voltage from the second input node to the first output node; and a second logical circuit configured to receive a signal based at least in part on the bistable state and a voltage from the second input node and output a logical combination of the signal based at least in part on the bistable state and the voltage from the second input node to the second output node; wherein the second input node of a first circuit module of the plurality of circuit modules is connected to a voltage source, and the first output node and the second output node of the first circuit module of the plurality of circuit modules are each connected to a different respective second input node of another circuit module of the plurality of circuit modules.

Aspects can include one or more of the following features.

The second input nodes of each other circuit module of the plurality of circuit modules not including the first circuit module of the plurality of circuit modules are connected to a different respective output node of a circuit module of the plurality of circuit modules.

Each circuit module of the plurality of circuit modules having the first output node connected to a circuit module of the plurality of circuit modules has the second output node connected a different respective circuit module of the plurality of circuit modules.

Each circuit module of the plurality of circuit modules is configured to produce a bistable state that varies over time between a first stable voltage and a second stable voltage, where a fraction of time that the bistable state spends at the first stable voltage is associated with a first probability.

Each circuit module of the plurality of circuit modules further comprises a level-shifter circuit configured to shift one or more of the first stable voltage or the second stable voltage.

The level-shifter circuit is configured to add a reference voltage to or subtract a reference voltage from one or more of the first stable voltage or the second stable voltage.

Each of the first logical circuit and the second logical circuit in each circuit module of the plurality of circuit modules comprises a NAND gate.

Each of the first logical circuit and the second logical circuit in each circuit module of the plurality of circuit modules that does not have a first output and a second output connected to respective circuit modules of the plurality of circuit modules comprises an AND gate.

Each of the first logical circuit and the second logical circuit in each circuit module of the plurality of circuit modules that does not have a first output and a second output connected to respective circuit modules of the plurality of circuit modules comprise an AND gate.

In another aspect, in general, an apparatus comprises: a metastable circuit module including more than two output nodes, wherein the more than two output nodes are associated with a bistable state that varies over time between a first stable voltage and a second stable voltage, where a fraction of time that the bistable state spends at the first stable voltage is associated with a probability; a plurality of noise circuits, where each noise circuit of the plurality of noise circuits is configured to produce a voltage distribution; and a mixer circuit comprising more than two gate circuits, where each gate circuit of the more than two gate circuits is connected to a respective output node of the metastable circuit module and to a respective noise circuit; wherein the mixer circuit is configured to produce a voltage distribution that is based at least in part on each probability associated with the metastable circuit module and each voltage distribution associated with a respective noise circuit of the plurality of noise circuits.

Aspects can include one or more of the following features.

Each gate circuit of the more than two gate circuits of the mixer circuit comprises one or both of a p-type metal-oxide-semiconductor transistor, or an n-type metal-oxide-semiconductor transistor.

Each gate circuit of the more than two gate circuits of the mixer circuit comprises a first inverter circuit, a second inverter circuit, a first transistor having a first body terminal, a first gate terminal, a first source terminal, and a first drain terminal, and a second transistor having a second body terminal, a second gate terminal, a second source terminal, and a second drain terminal.

The first body terminal and the second body terminal are connected to a common ground, the first drain terminal and the second drain terminal are connected to a first node that receives a voltage distribution from a respective noise circuit, an output of the first inverter circuit is connected to the first gate terminal at a second node, the second inverter circuit is connected to the second node, an output of the second inverter circuit is connected to the second gate terminal, and the first source terminal and the second source terminal are connected to a third node.

The first transistor is a p-type metal-oxide-semiconductor transistor and the second transistor is an n-type metal-oxide-semiconductor transistor.

Each noise circuit of the plurality of noise circuits is configured to produce a voltage distribution that is substantially Gaussian.

Each noise circuit of the plurality of noise circuits comprises an inverter circuit.

The metastable circuit module comprises a plurality of circuit modules and each circuit module of the plurality of circuit modules comprises a metastable circuit configured to receive a bias voltage and produce a bistable state based at least in part on the bias voltage, where the bistable state varies over time between a third stable voltage and a fourth stable voltage and a fraction of time that the bistable state spends at the third stable voltage is associated with a first probability.

Each circuit module of the plurality of circuit modules further comprises a level-shifter circuit that is configured to add a reference voltage to or subtract a reference voltage from each of the third stable voltage and the fourth stable voltage.

Each circuit module of the plurality of circuit modules is connected to a respective output node of the metastable circuit module.

The first stable voltage is equal to the third stable voltage of each metastable circuit in the plurality of circuit modules, and the second stable voltage is equal to the fourth stable voltage of each metastable circuit in the plurality of circuit modules.

Aspects can have one or more of the following advantages.

Without using some of the circuit architectures described herein, some circuits can incorporate a cascading sequence of mixer circuits configured such that each mixer circuit has an output connected to an input of a subsequent mixer circuit. Each of these mixer circuit can be connected to a respective metastable circuit having two outputs. In these circuits, an input signal traveling through the sequence of mixer circuits can be degraded. In some examples, this signal degradation can increase as the sequence of mixer circuits increases. In contrast, utilizing circuit architectures described herein can be associated with lower degradation of signals.

Other features and advantages will become apparent from the following description, and from the figures and claims.

BRIEF DESCRIPTION OF THE DRAWINGS

The disclosure is best understood from the following detailed description when read in conjunction with the accompanying drawing. It is emphasized that, according to common practice, the various features of the drawing are not to-scale. On the contrary, the dimensions of the various features are arbitrarily expanded or reduced for clarity. The plots resulting from numerical simulations, as indicated below, are working examples of experimental results associated with some of the techniques described herein, and other plots are prophetic examples of expected experimental results.

FIG. **1** is a schematic diagram of an example circuit architecture.

FIG. **2A** is a schematic diagram of an example circuit architecture comprising circuit modules.

FIGS. **2B-2C** are schematic diagrams of example circuit modules.

FIGS. **3A-3D** are schematic diagrams of example metastable circuits.

FIG. **4A** is a schematic diagram of an example NAND gate.

FIG. **4B** is a schematic diagram of an example AND gate.

FIGS. **5A-5C** are schematic diagrams of example circuit architectures comprising circuit modules.

FIG. **6** is a schematic diagram of an example level-shifter circuit.

FIG. **7A** is a schematic diagram of an example mixer circuit.

FIGS. **7B-7D** are schematic diagrams of example sub-circuits of a mixer circuit.

FIGS. **7E-7F** are schematic diagrams of example mixer circuits.

FIG. **8** is a schematic diagram of an example noise circuit.

FIGS. **9A-9C** are plots of numerical simulations associated with a metastable circuit.

FIG. **10** is a plot of numerical simulations associated with a metastable circuit.

DETAILED DESCRIPTION

Some integrated circuits can be operated in a regime wherein fundamental thermodynamic processes characterize their behavior. In some examples, this operation can comprise driving a transistor in an integrated circuit using a voltage that is below a threshold voltage associated with the transistor such that the transistor is operating in the "sub-threshold regime" or below the sub-threshold limit. By way of example, some transistors operating in the sub-threshold regime can be driven at voltages between 0 mV and 175 mV. Some electronic devices comprising these transistors can harness thermodynamic processes to perform operations or computations.

A complementary metal-oxide-semiconductor (CMOS)-based circuit architecture, i.e., forming an apparatus, operating in a sub-threshold regime can be configured to sample from a mixture of two or more one-dimensional probability distributions. Some CMOS architectures can comprise n-type metal-oxide-semiconductor (nMOS) or p-type metal-oxide-semiconductor (pMOS) transistors. nMOS transistors comprise semiconductors doped with an electron donor element, such as phosphorus, arsenic or antimony. pMOS transistors comprise semiconductors doped with an electron acceptor element such as boron, aluminum, or gallium.

Such circuit architectures can comprise one or more of a first type of subcircuit that are each configured to produce a distribution of voltages according to some probability distribution. In some examples, this probability distribution of voltages can be a Gaussian distribution. Some circuit architectures can further comprise one or more of a second type of subcircuit that are each configured to produce a stable voltage over a period of time according to a probability. Some circuit architectures can combine the first type of subcircuit and the second type of subcircuit such that the circuit architecture can sample from a sum of the probability distributions associated with the first type of circuit, wherein each probability distribution is weighted by a probability associated with the second type of subcircuit. In some circuit architectures, the first type of subcircuit can be configured to produce a Gaussian distribution or a distribution that is substantially Gaussian, such that the circuit architecture samples from a Gaussian mixture model (GMM).

A GMM can be defined as a weighted sum of Gaussian components given by

$$p(x) = \sum_{i=1}^{K} \pi_i \mathcal{N}(x|\mu_i, \sigma_i^2), \qquad (1)$$

where $\pi_i$ are the mixture weights (which sum to 1), $\mu_i$ are the means and $\sigma_i^2$ are the variances of the Gaussian components. By adjusting the $\pi_i$, $\mu_i$ and $\sigma_i^2$ parameters, the mixture can be made to approximate any target distribution. Techniques such as the Expectation-Maximization (EM) algorithm can be employed to fit the parameters of the GMM to data from the target distribution, effectively allowing the GMM to approximate the underlying distribution. Once a GMM is fitted to approximate the target distribution, sampling from the GMM can be done in the following steps

- Sample a component i according to the mixture weights $\pi_i$.

- Sample from the chosen Gaussian component $\mathcal{N}(x|\mu_i, \sigma_i^2)$.

By repeating the above steps, samples from the Gaussian mixture can be obtained, which in turn approximates samples from the original distribution.

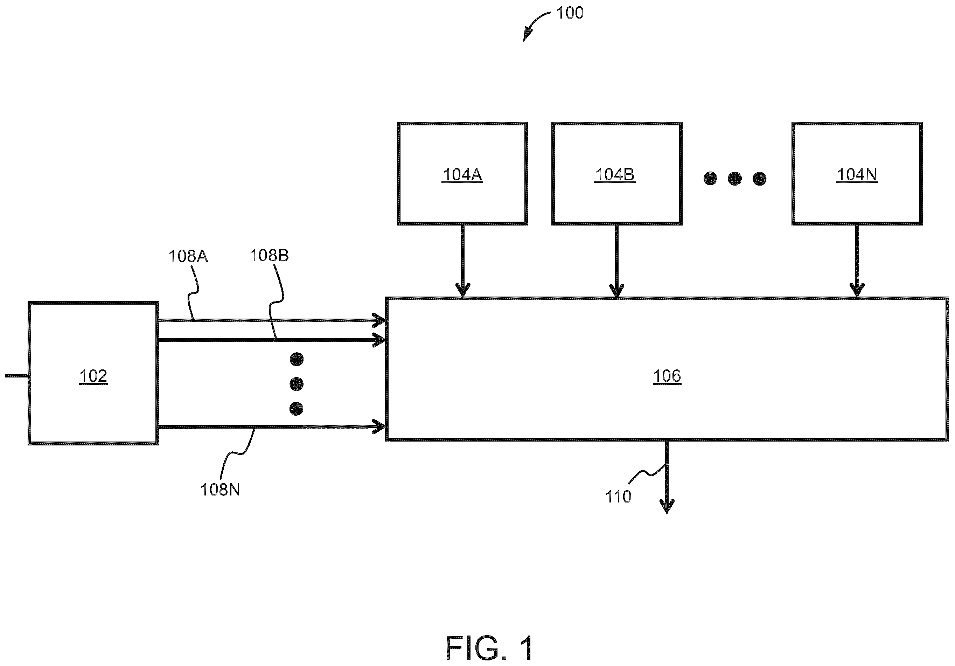

FIG. 1 depicts an example circuit architecture 100 that can be utilized to sample from a mixture of probability distributions. The circuit architecture 100 comprises a metastable circuit 102, a plurality of noise circuits 104A-104N, i.e., a noise circuit 104A, a noise circuit 104B, and a noise circuit 104N, and a mixer circuit 106. The metastable circuit 102 has a plurality of outputs 108A-108N, i.e., an output 108A, an output 108B, and an output 108N. Each output of the plurality of outputs 108A-108N is associated with a bistable state that varies over time between a first stable voltage and a second stable voltage where a fraction of time that the bistable state spends at the first stable voltage is associated with a probability. Each noise circuit of the plurality of noise circuits 104A-104N is configured to produce a respective voltage distribution. The mixer circuit 106 is configured to produce, to an output 110, a distribution that is based at least in part on each voltage distribution associated a respective noise circuit of the plurality of noise circuits 104A-104N and and each probability associated with a respective output of the plurality of outputs 108A-108N of the metastable circuit 102. In some implementations of the circuit architecture 100, the output distribution from a mixer circuit 106 can be a Gaussian mixture model. In other words, the circuit architecture 100 is configured to stochastically mix a discrete source of noise produced by a metastable circuit 102 with a plurality of continuous sources of noise produced by the plurality of noise circuits 104A-104N.

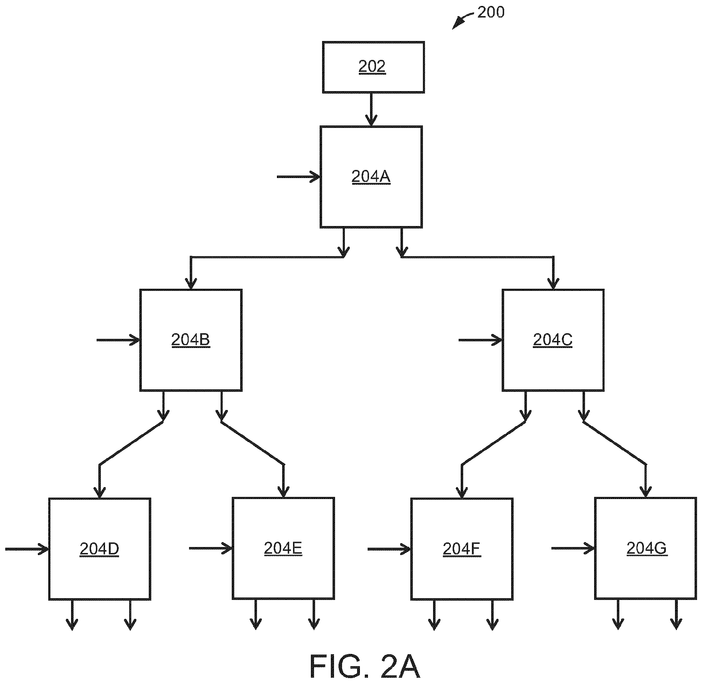

FIG. 2A depicts an example circuit architecture 200 that can be utilized as a metastable circuit 102 in the circuit architecture 100. The circuit architecture 200 comprises a plurality of circuit modules 204A-204G, i.e., a circuit module 204A, a circuit module 204B, a circuit module 204C, a circuit module 204D, a circuit module 204E, a circuit module 204F, and a circuit module 204G. Each circuit module of the plurality of circuit modules 204A-204G has a first input node, a second input node, a first output node, and a second output node. The second input node of a circuit module 204A is connected to a voltage source 202 and the first output node and the second output node of the circuit module 204A are each connected to a different respective second input node of circuit module 204B and circuit module 204C. The first output node and the second output node of circuit module 204B are each connected to a respective second input node of circuit module 204D and circuit module 204E. The first output node and the second output node of circuit module 204C are each connected to a respective second input node of circuit module 204F and circuit module 204D.

The circuit architecture 200 depicted in FIG. 2A comprises a plurality of circuit modules 204A-204G, i.e., seven circuit modules, arranged in a "tree-like" structure with three layers of circuit modules. Some circuit architectures can comprise more than three layers and more than seven circuit modules. For instance, in some circuit architectures, circuit modules can be connected to each of the outputs of each circuit module of the plurality of circuit modules 204D-204G. Some circuit architectures can comprise a cascading series of circuit modules arranged with a "tree-like" structure with $L$ layers. In general, for a circuit architecture comprising $L$ layers, bottom-most layer of circuit modules has $2^L$ outputs. A circuit architecture can be configured with a plurality of circuit modules depending on a desired application.

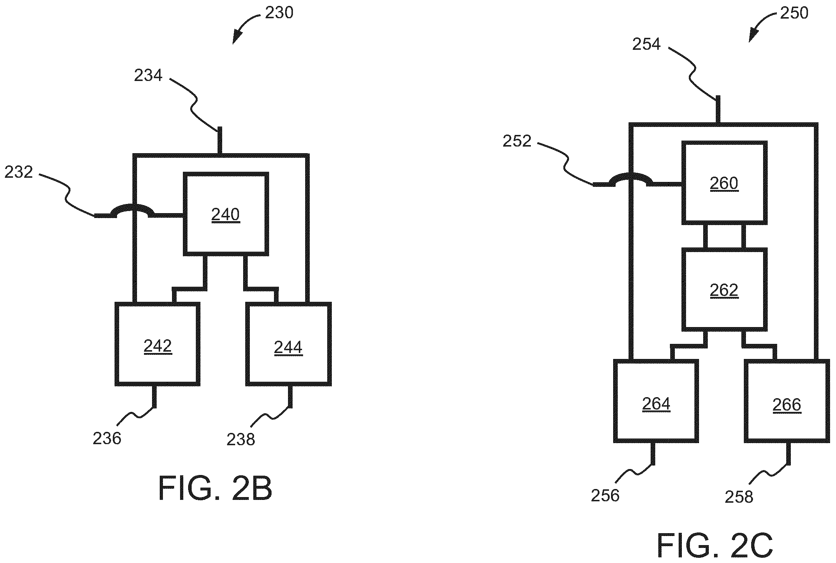

FIG. 2B depicts an example circuit module 230 that can be used as each circuit module of the plurality of circuit modules 204A-204G in circuit architecture 200. The circuit module 230 comprises a first input node 232, a second input node 234, a first output node 236 and a second output node 238. The circuit module 230 comprises a circuit 240. The two outputs of circuit 240 are each directed to a first logical circuit 242 and a second logical circuit 244. The first logical circuit 242 and the second logical circuit 244 are each configured to receive the outputs from the circuit 240 and output, to the first output node 236 and second output node 238, respectively, a logical combination of the outputs from the circuit 240 with a voltage from the second input node 234.

In some implementations, the circuit 240 can comprise a metastable circuit configured to receive a bias voltage from the first input node 232 and produce, based at least in part on the bias voltage, a first bistable state. The first bistable state varies over time between a first stable voltage and a second stable voltage, where a fraction of time that the first bistable state spends at the first stable voltage is associated with a first probability $p$ and a fraction of time that the first bistable state spends at the second stable voltage is associated with second probability $1 - p$ that is associated with the first probability. A first logical circuit 242 is configured to receive a signal based at least in part on the first bistable state, i.e., the first stable voltage or the second stable voltage, and a second logical circuit 244 is configured to receive a signal based at least in part on the first bistable state, i.e., the first stable voltage or the second stable voltage. The first logical circuit 242 can receive the signal based at least in part on first bistable state and a voltage from the second input node 234 and output a logical combination of signal based at least in part on the first bistable state and the voltage from the second input node 234 to the first output node 236. The second logical circuit 244 can receive the signal based at least in part on the first bistable state and a voltage from the second input node 234 and output a logical combination of the signal based at least in part on the first bistable state and the voltage from the second input node 234 to the second output node 238.

Some metastable circuits can produce stable voltages that can be used to drive other circuits. In some examples, the stable voltages produced by a metastable circuit might not be large enough to drive other circuits. Some circuit modules can comprise a level-shifter circuit configured to increase or amplify a respective voltage. FIG. 2C depicts an example circuit module 250 that comprises a similar circuit architecture to circuit module 230 and can be used as each circuit module of the plurality of circuit modules 204A-204G in circuit architecture 200. The circuit module 250 comprises a first input node 252, a second input node 254, a first output node 256 and a second output node 258. The circuit module 250 comprises a metastable circuit 260 configured to receive a bias voltage from the first input node 252 and produce, based at least in part on the bias voltage, a first bistable state that varies over time between a first stable voltage and a second stable voltage. The first bistable state is directed to a level-shifter circuit 262 that amplifies or shifts voltages associated with the first bistable state. In other words, the level-shifter circuit is configured to shift a signal based at least in part on first bistable state, i.e., one or more of the first stable voltage or the second stable voltage. The level-shifter circuit is connected to a first logical circuit 264 and a second logical circuit 266. The first logical circuit 264 is configured to receive a signal based at least in part on the first bistable state and a voltage from the second input node 254 and output a logical combination of the signal based at least in part on the first bistable state and the voltage from the second input node 254 to the first output node 256. The second logical circuit 266 is configured to receive a signal based at least in part on the first bistable state and a voltage from the second input node 254 and output a logical combination of the signal based at least in part on the first bistable state and the voltage from the second input node 254 to the second output node 258.

In some implementations, external circuitry can be configured to interact with a circuit architecture or a circuit, or portions thereof. For instance, some external circuitry can interact with a circuit architecture by applying voltages to or reading voltages from a circuit architecture or portions thereof. For instance, control circuitry can be configured to apply control signals or generate voltages to be applied to a circuit. In some examples, readout circuitry configured to read, sample, and/or store voltages from a circuit. In some implementations, circuitry configured to apply control signals to a circuit architecture, or portions thereof, can be positioned on a separate integrated circuit chip or device as the circuit architecture. In some examples, control signals applied to a circuit or signals produced by a circuit can be weak. In some implementations, to mitigate weak signals, circuitry configured to apply control signals to a circuit architecture, or portions thereof, can be positioned in proximity to the circuit architecture, i.e., on the same integrated circuit chip or device that comprises the circuit architecture. In some implementations, circuitry configured to readout signals from a circuit architecture, or portions thereof, can be positioned in proximity to the circuit architecture, i.e., on the same integrated circuit chip or device that comprises the circuit architecture. Positioning one or both of the readout circuitry or the control circuitry in proximity to a circuit architecture can be useful to mitigate losses associated with transmitting weak signals over larger distances.

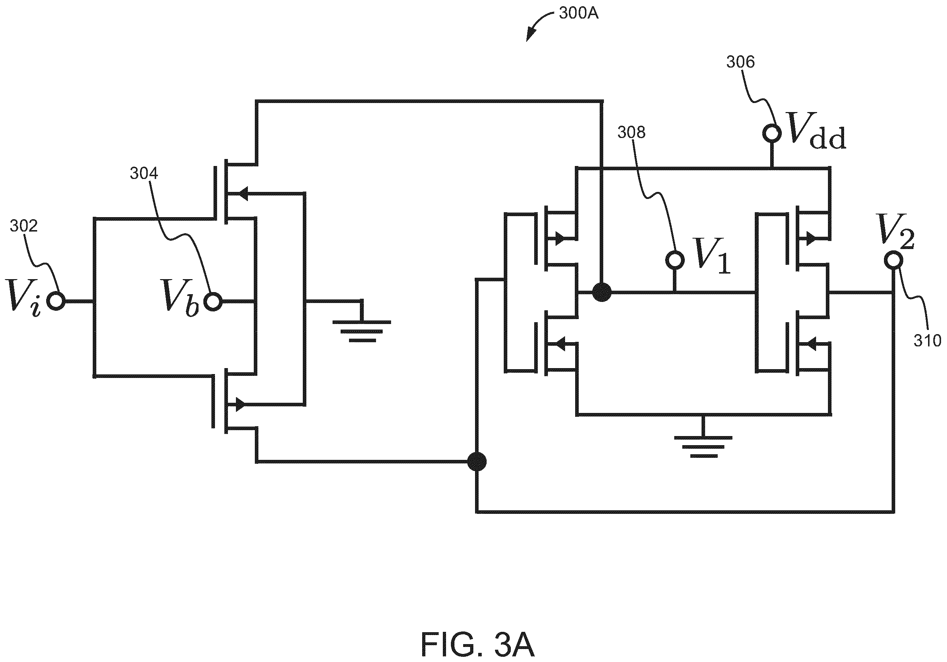

In some circuit architectures, the metastable circuit can be a probability bit circuit, also known as a p-bit. An example circuit 300A that can be used as a p-bit is shown in FIG. 3A. The circuit 300A comprises a terminal 302, a terminal 304, a terminal 306, a terminal 308, and a terminal 310 each associated with respective voltages $V_i$, $V_b$, $V_{dd}$, $V_1$, and $V_2$. For fixed voltages $V_{dd}$, $V_b$ and $V_i$, the state of the p-bit at the terminal 308 and the terminal 310 comprises the output voltages $V = (V_1, V_2)$. The p-bit is a bistable circuit with two metastable states $\boldsymbol{V}_x \simeq (0, V_{dd})$ and $\boldsymbol{V}_y \simeq (V_{dd}, 0)$. At steady state, the p-bit can be in the metastable state $\boldsymbol{V}_x$ with probability $p$, or in the metastable state $\boldsymbol{V}_y$ with probability $1 - p$. The particular value of p is controlled by the input voltage $V_i$. When $V_i$ approaches $V_{dd}$, $p$ tends to 1, and when $V_i$ approaches 0, $p$ tends to 0. The precise relationship between $p$ and $V_i$ can be tuned by the biasing voltage $V_b$.

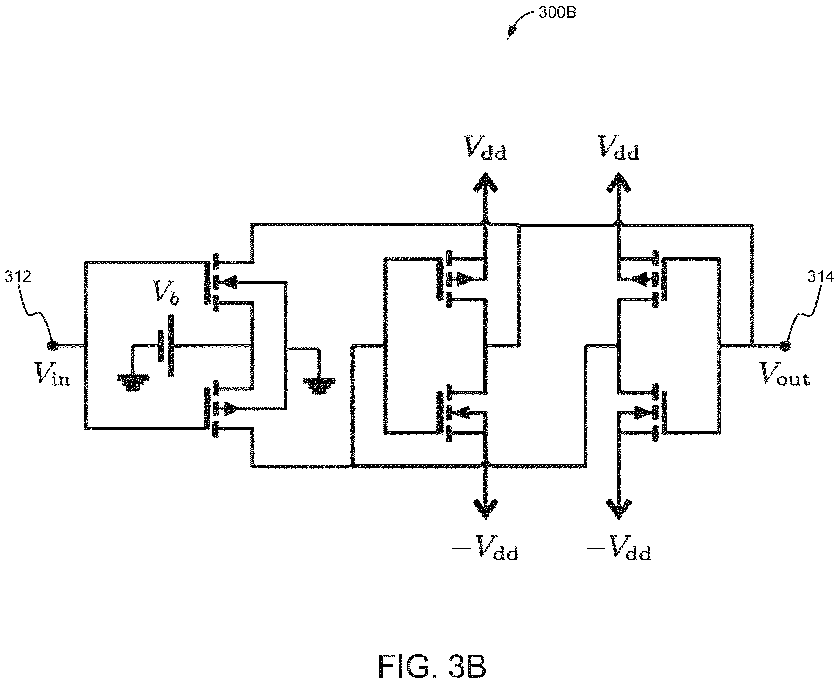

The circuit 300A comprises two outputs. Some p-bits can comprise one output. FIG. 3B depicts an example circuit 300B that can be used as a *p*-bit, i.e., produce a bistable state. The circuit 300B comprises pMOS and nMOS transistors, an input terminal 312 associated with a voltage $V_{in}$, an output terminal 314 associated with a voltage $V_{out}$, and terminals associated with voltages $V_{dd}$. The circuit 300B is configured to receive a bias voltage $V_b$. At steady state, the output terminal 314 can be in the metastable state $V_{out} = V_{dd}$ with probability $p$, or in the metastable state $V_{out} = -V_{dd}$ with probability $1 - p$.

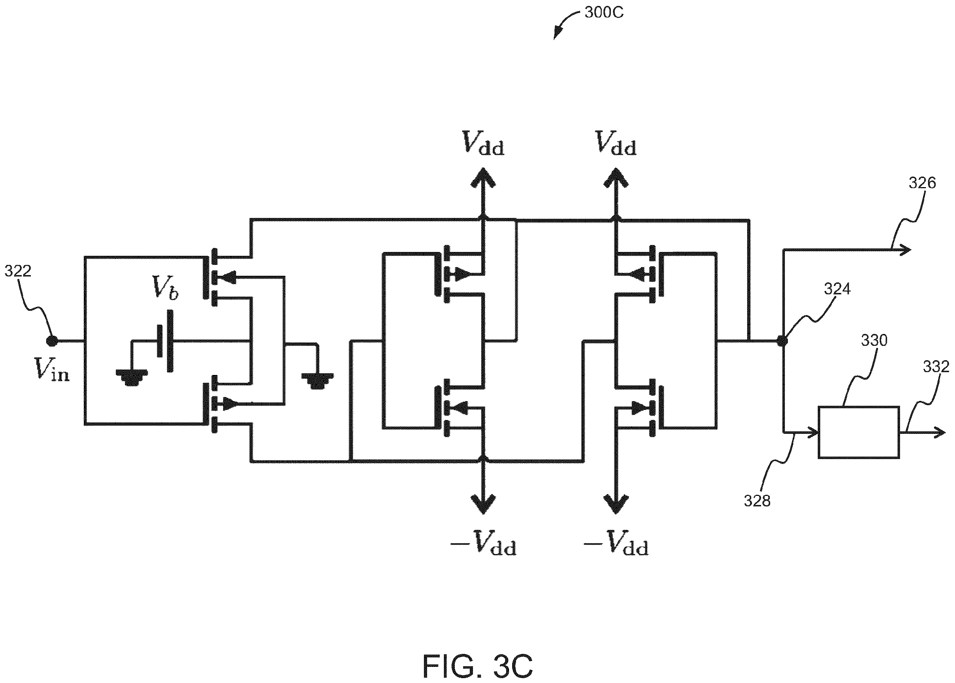

In some examples, the output of a p-bit circuit can be split into a first output and a second output and each of the first output and the second output can be directed to other circuitry. FIG. 3C depicts an example circuit 300C comprising a similar configuration as the circuit 300B shown in FIG. 3B. The circuit 300C comprises pMOS and nMOS transistors, an input terminal 322 associated with a voltage $V_{in}$, an output terminal 324 associated with a voltage $V_{out}$, and terminals associated with voltages $V_{dd}$. The circuit 300C is configured to receive a bias voltage $V_b$. At steady state, the output terminal 324 can be in the metastable state $V_{out} = V_{dd}$ with probability $p$, or in the metastable state $V_{out} = -V_{dd}$ with probability $1 - p$. The output at the output terminal 324 is split into a first signal 326 and a second signal 328, i.e., signals based on the bistable state. The second signal 328 is directed to an inverter circuit 330 to produce an inverted signal 332. In other words, the inverted signal 332 and the first signal 326 are both based on the bistable state.

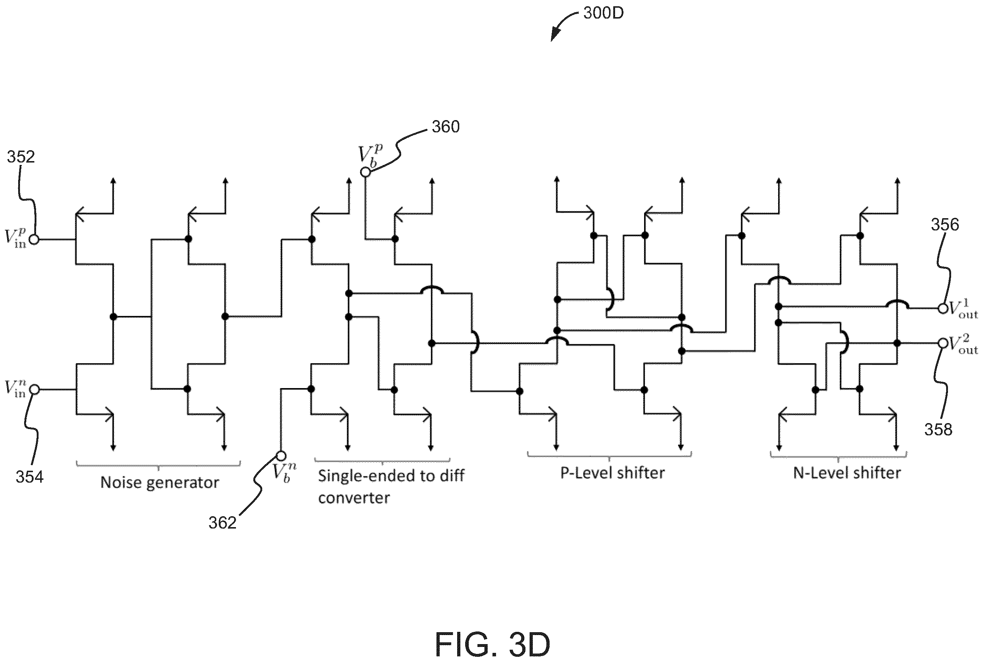

An example circuit 300D that can be used as a *p*-bit, i.e., to produce a bistable state, is shown in FIG. 3D. The circuit 300D comprises a first input 352, a second input 354, a first output 356, and a second output 358. The first input 352 is associated with a voltage $V_{in}^{p}$, the second input 354 is associated with a voltage $V_{in}^{n}$ the first output 356 is associated with a voltage $V_{out}^{1}$, and the second output 358 is associated with a voltage $V_{out}^{2}$. The circuit 300D also has a bias 360 associated with a voltage $V_{b}^{p}$ and a bias 362 associated with a voltage $V_{b}^{n}$ that can be used to control the first output 356 and the second output 358. The bias 360 and the bias 362 can be used to address variations in transistor parameters that can occur during the fabrication process. The component of the circuit 300D labeled "Single-ended to diff converter" can take the noise generated from the first module and outputs two noisy signals that can be anticorrelated. The circuit 300D also comprises a P-level shifter that can shift voltages upwards and a N-level shifter that can shift voltages downwards.

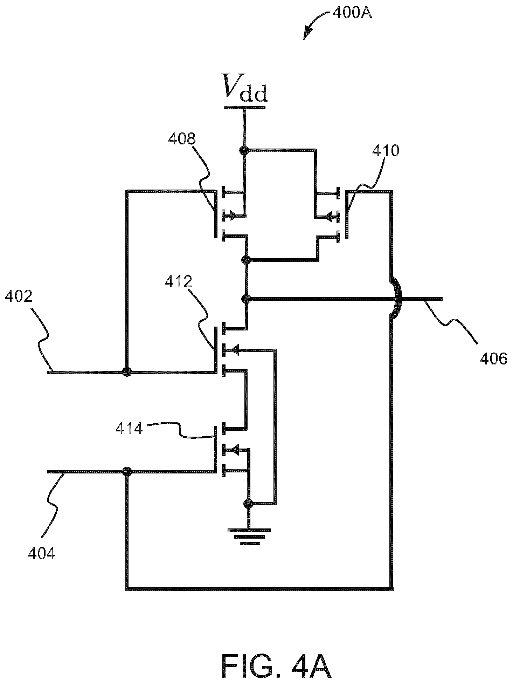

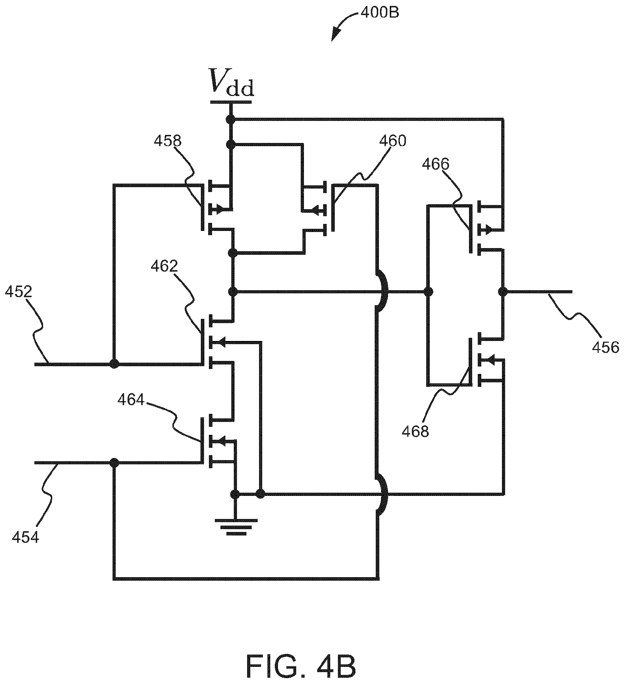

FIG. 4A depicts an example CMOS NAND gate 400A that can be utilized as the first logical circuit 242 or the second logical circuit 244 in circuit module 230 or the first logical circuit 264 or the second logical circuit 266 in circuit module 250. The CMOS NAND gate 400A comprises a first input 402, a second input 404, output 406, a transistor 408, a transistor 410, a transistor 412, and a transistor 414. FIG. 4B depicts an example CMOS AND gate 400B that can be utilized as the first logical circuit 242 or the second logical circuit 244 in circuit module 230 or the first logical circuit 264 or the second logical circuit 266 in circuit module 250. The CMOS AND gate 400B comprises a CMOS NAND gate attached to an inverter, sometimes referred to as an inverter circuit. The CMOS AND gate 400B comprises a first input 452, a second input 454, output 456, a transistor 458, a transistor 460, a transistor 462, a transistor 464, a transistor 466, and a transistor 468.

A truth table for a circuit module 230 comprising an inverter as the circuit 240 and AND gates as the first logical circuit 242 and the second logical circuit 244 is shown in table 1, where OA corresponds to the first output node 236 and OB corresponds to the second output node 238. Such a circuit module can be referred to as a de-multiplexer circuit or a "demux" circuit. A

Table 1 Truth table for a demux circuit.

| b | l | OA | OB |
|---|---|----|----|
| 0 | 0 | 0 | 0 |
| 0 | 1 | 0 | 1 |
| 1 | 0 | 0 | 0 |
| 1 | 1 | 1 | 0 |

circuit module 230 comprising a metastable circuit as the circuit 240 and AND gates as the first logical circuit 242 and the second logical circuit 244 can be referred to as a probabilistic de-multiplexer (pdemux) circuit. A circuit module 250 comprising a metastable circuit 260, a level-shifter circuit 262, a first logical circuit 264, and a second logical circuit 266, wherein the first logical circuit 264 and the second logical circuit 266 are configured as AND gates, can also be referred to as a pdemux circuit.

A complementary circuit module to the pdemux circuit module can comprise NAND gates as the first logical circuit 242 and the second logical circuit 244. A truth table for a circuit module 230 comprising an inverter as the circuit 240 and NAND gates as the first logical circuit 242 and the second logical circuit 244 is shown table 2, where OA corresponds to the first output node 236 and OB corresponds to the second output node 238. Such a circuit module can be referred to as a complementary de-multiplexer circuit or a $\overline{demux}$ circuit. A circuit module 230

Table 2 Truth table for the $\overline{demux}$ circuit.

| b | l | OA | OB |
|---|---|----|----|
| 0 | 0 | 1 | 1 |
| 0 | 1 | 1 | 0 |
| 1 | 0 | 1 | 1 |
| 1 | 1 | 0 | 1 |

comprising a metastable circuit as the circuit 240 and NAND gates as the first logical circuit 242 and the second logical circuit 244 can be referred to as a complementary probabilistic de-multiplexer ($\overline{pdemux}$) circuit. A circuit module 250 comprising a metastable circuit 260, a level-shifter circuit 262, a first logical circuit 264, and a second logical circuit 266, wherein the first logical circuit 264 and the second logical circuit 266 are configured as NAND gates, can also be referred to as a $\overline{\text{pdemux}}$ circuit.

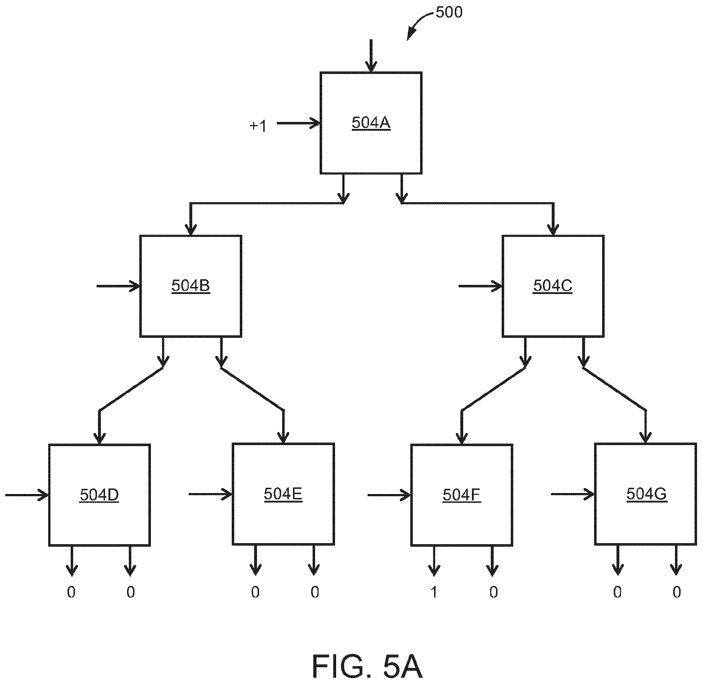

Some CMOS circuit architectures can comprise combinations of logical circuits distributed throughout circuit modules such the circuit architecture can be controlled to output a voltage selectively to a particular output node at any given time. This configuration can be referred to as "one-hot." An example circuit architecture 500 that can produce a one-hot output node is depicted in FIG. 5A. The circuit architecture 500 comprises a plurality of circuit modules 504A-504G, i.e., a circuit module 504A, a circuit module 504B, a circuit module 504C, a circuit module 504D, a circuit module 504E, a circuit module 504F, and a circuit module 504G. Each circuit module of the plurality of circuit modules 504A-504G is configured as a pdemux circuit comprising two AND gates as the logical circuits. The input to the circuit module 504A in the first layer is set to +1, i.e. a high voltage is used. One output node of the circuit module 504F has an output of 1 while each other output nodes have outputs of 0, hence the circuit is one-hot. Expanding this circuit architecture to more than seven circuit modules, a one-hot circuit architecture can be constructed by building a tree of pdemux circuits.

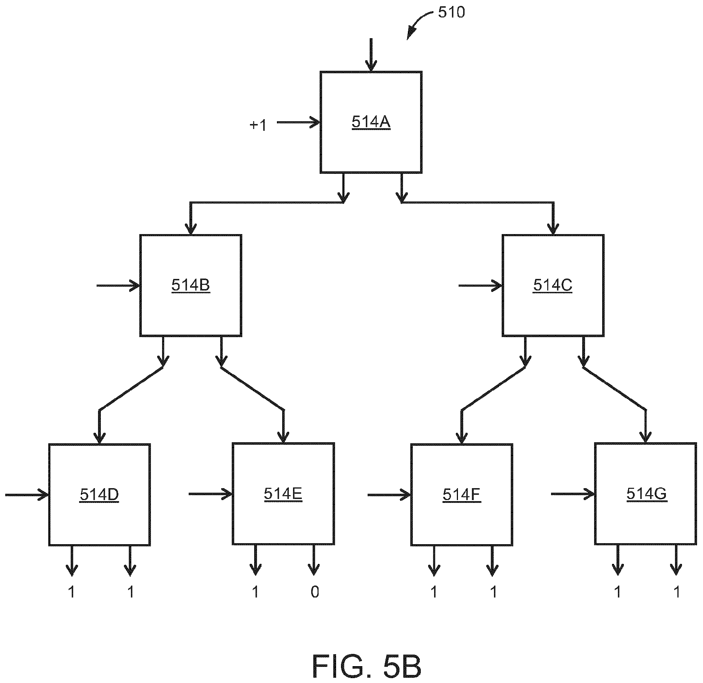

Alternatively, some CMOS circuit architectures can comprise combinations of logical circuits distributed throughout circuit modules such that every output node is outputting a voltage except for a single selected output node. This configuration is referred to as "one-cold." An example circuit architecture 510 that can produce a one-cold output node is depicted in FIG. 5B. The circuit architecture 510 comprises a plurality of circuit modules 514A-514G, i.e., a circuit module 514A, a circuit module 514B, a circuit module 514C, a circuit module 514D, a circuit module 514E, a circuit module 514F, and a circuit module 514G. Each circuit module of the plurality of circuit modules 514A-514C is configured as a pdemux circuit comprising two AND gates as the logical circuits. Each circuit module of the plurality of circuit modules 514D-514G is configured as a $\overline{\text{pdemux}}$ circuit comprising two NAND gates as the logical circuits. The input to the circuit module 514A in the first layer is set to +1, i.e. a high voltage is used. One output node of the circuit module 514E has an output of 0 while each other output node has an output of 1, hence the circuit is one-cold. Expanding this circuit architecture to more than seven circuit modules, the bottom layer of circuit modules in the tree of circuit modules are $\overline{\text{pdemux}}$ circuits while the other circuit modules are pdemux circuits. In other words, for a circuit architecture comprising a tree of circuit modules with $L$ layers in the tree, the first $L$ - 1 layers are pdemux circuits, whereas the final $L^{\text{th}}$ layer are $\overline{\text{pdemux}}$ circuits.

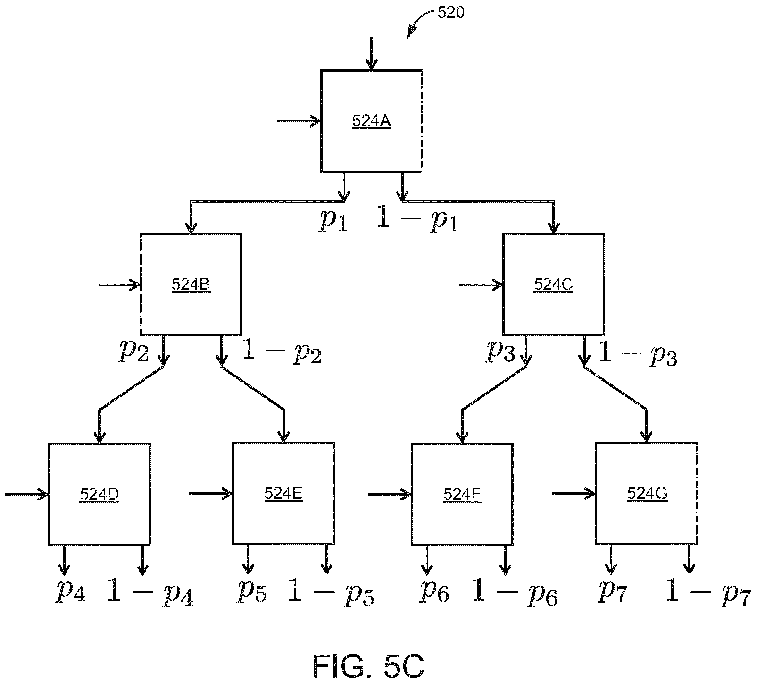

Referring back to FIG. 2A, the circuit architecture 200 comprises a plurality of circuit modules, and each circuit module can comprise a p-bit circuit. Such a circuit architecture combining multiple p-bit circuits can be referred to as a "p-dit" circuit. As previously described, each $p$-bit circuit is associated with a bistable state associated with a first probability $p$ and a second probability 1 - $p$. The outputs of each circuit module are thus also associated with the first probability and the second probability. An example circuit architecture 520 comprising a plurality of circuit modules 524A-524G, i.e., a circuit module 524A, a circuit module 524B, a circuit module 524C, a circuit module 524D, a circuit module 524E, a circuit module 524F, and a circuit module 524G, is depicted in FIG. 5C. Probabilities associated with stable voltages of the bistable state are also shown for each circuit module. Each probability can be tuned by applying a bias voltage to a respective p-bit circuit in a circuit module.

In some examples, a plurality of circuit modules can be configured such that each p-bit is configured to produce a bistable state that varies over time between a first stable voltage and a second stable voltage, where all of the first stable voltages are substantially equal to or within 10% of one another and all of the second stable voltages are substantially equal to or within 10% of one another. Such implementations can be associated with flexibility in designing circuit architectures.

As shown in FIGS. 5A-5C, the one-cold or one-hot encoding is probabilistic and the position of the 0 (or 1) bit can shift depending on the probabilistic outcomes of each $p$-bit in the pdemux and $\overline{\text{pdemux}}$ circuits at any given moment. Further, the output distribution for the one-cold or one-hot encoding can be biased by adjusting the $p$-bits controls $b$ in each of the pdemux and $\overline{\text{pdemux}}$ circuits. For $p$-dit circuit with a tree structure, if $L$ layers are used, the number of outputs in the final layer is $2^L$, and the number of bias inputs $b$ is $2^L$ - 1. Thus, the tree structure can allow for a full parametrization of the probability distribution for the position of the cold or hot bit.

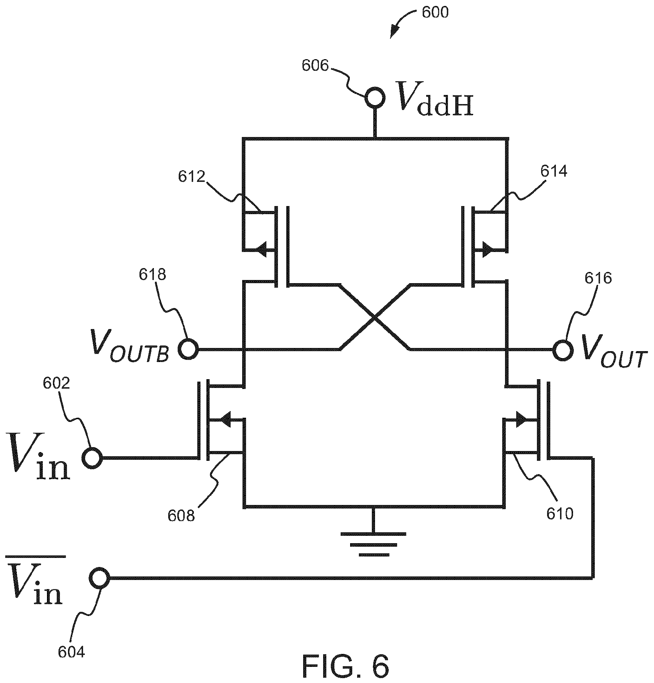

Referring back to FIG. 2C, some circuit modules can comprise a level-shifter circuit connected to the outputs of a metastable circuit. In some examples, a level-shifter circuit can be configured to translate input voltages, i.e., add a reference voltage to or subtract a reference voltage from the input voltages. An example circuit 600 configured as a level-shifter circuit is depicted in FIG. 6. The circuit 600 comprises an input port 602 associated with an input voltage $V_{\text{in}}$, an input port 604 associated with an input voltage $\overline{V_{\text{in}}}$, and a terminal 606 associated with a voltage $V_{ddH}$. The circuit 600 comprises a first nMOS transistor 608, a second nMOS transistor 610, a first pMOS transistor 612, and a second pMOS transistor 614. In other words, the circuit 600 comprises two cross-coupled nMOS driver transistors and two pMOS latches. An output node 616 and an output node 618 are each associated with voltages $V_{OUT}$ and $V_{OUTB}$ respectively. When the voltages $V_{\text{in}}$ and $\overline{V_{\text{in}}}$ are low and high, the first nMOS transistor 608 is off and the second nMOS transistor 610 is on. The second nMOS transistor 610 then pulls down $V_{OUT}$, causing the first pMOS transistor 612 to turn on, which in turn results in $V_{OUTB}$ increasing to $V_{ddh}$ and also causes the second pMOS transistor 614 to turn off. When the second pMOS transistor 614 is off, $V_{OUT}$ drops to ground. The opposite happens when the voltages $\overline{V_{\text{in}}}$ and $\overline{V_{\text{in}}}$ are high and low, resulting in $V_{OUT}$ being at the voltage $V_{ddh}$.

In some examples, if a $p$-bit circuit is connected to a level-shifter circuit, an effective capacitance associated with the *p*-bit circuit can increase due to a capacitance associated with the level-shifter circuit. This capacitance increase can slow down transitions associated with the *p*-bit circuit. In some examples, a level-shifter circuit can be associated with a low input capacitance to mitigate this effect. More sophisticated designs of level-shifter circuits involving buffering input stages can also be implemented. For instance, two level-shifter circuits can be used, where the outputs of a first level-shifter circuit could be connected to the inputs of a second level-shifter circuit. In such an implementation, the first level-shifter circuit can have a lower capacitance than the second level-shifter circuit. A *p*-bit can be directly connected to the first level-shifter circuit such that the capacitance of the second level-shifter circuit does not affect the operation of the *p*-bit.

In some circuit architectures, the mixer circuit can comprise a *t*-gate multiplexer that can be configured to mix input distributions. In some examples, a *t*-gate multiplexer can comprise two or more *t*-gates, where a *t*-gate comprises one or more transistors and can effectively act as a switch when operating in the sub-threshold regime.

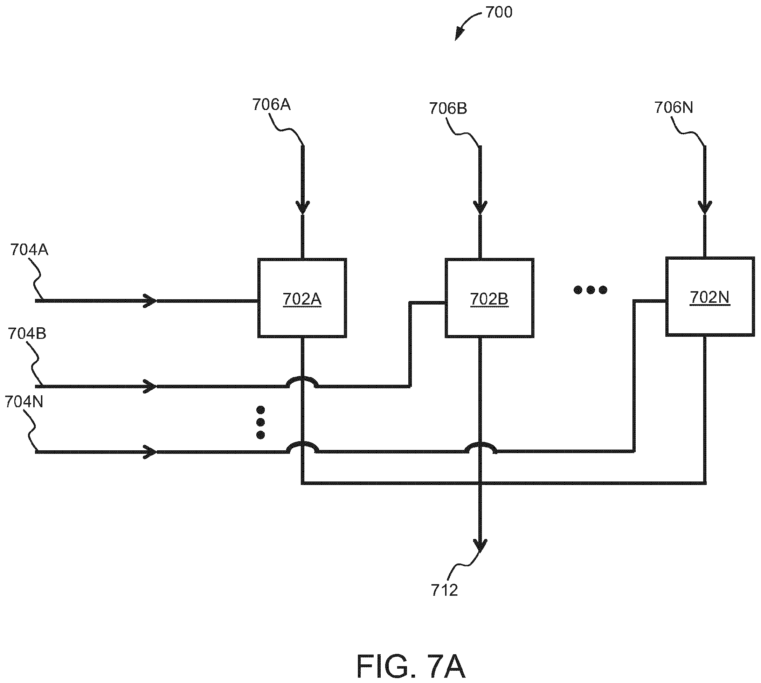

FIG. 7A depicts an example *t*-gate multiplexer circuit 700 comprising a plurality of gate circuits 702A-702N, i.e., a gate circuit 702A, a gate circuit 702B, and a gate circuit 702N. Each gate circuit of the plurality of gate circuits 702A-702N comprises a *t*-gate, where each *t*-gate comprises one or both of a pMOS transistor or nMOS transistor. The *t*-gate multiplexer circuit 700 has input nodes 704A-704N, i.e., an input node 704A, an input node 704B, and an input 704N, input nodes 706A-706N, i.e., an input node 706A, an input node 706B, and an input node 706N, and output node 712. In some circuit architectures, the input nodes 704A-704N can each be connected to a respective output of a *p*-dit circuit and can be used to control which of the *t*-gates in the plurality of gate circuits 702A-702N act as a short or open circuit. The input nodes 706A-706N can each be connected to respective noise circuit such that input voltages to the plurality of gate circuits 702A-702N are associated with some probability distribution determined by the noise circuit. The output node 712 can be associated with a voltage distribution that is a mixture of the input distributions from input nodes 706A-706N, with a particular weight attributed to each distribution that is dependent on the state of *p*-dit circuit which determines whether each *t*-gate in a respective gate circuit of the plurality of gate circuits 702A-702N is open or closed. The *t*-gates in the plurality of gate circuits 702A-702N are thus controlled by the state of the *p*-dit circuit connected to the input nodes 704A-704N.

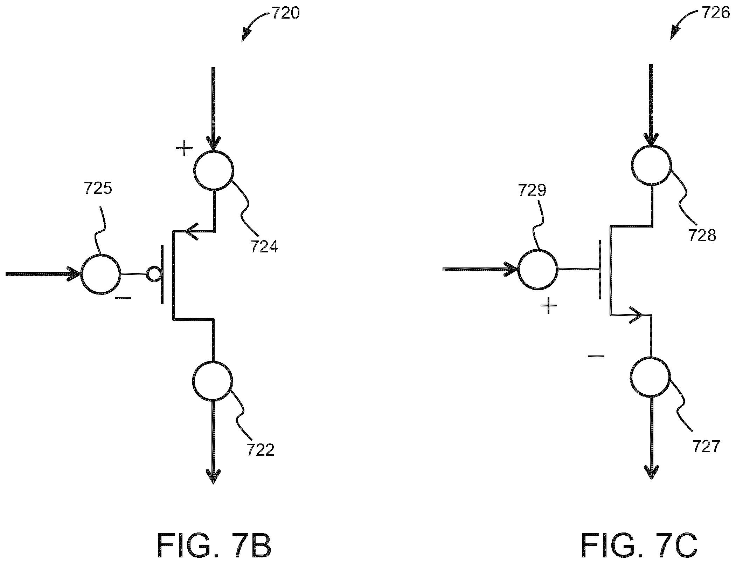

FIG. 7B depicts a pMOS transistor *t*-gate 720 that can be used as each gate circuit of the plurality of gate circuits 702A-702N in the *t*-gate multiplexer circuit 700. In some implementations, a *t*-gate multiplexer circuit 700 with a pMOS transistor *t*-gate 720 as each gate circuit of the plurality of gate circuits 702A-702N can be connected to a *p*-dit with one-cold encoding. The pMOS transistor *t*-gate 720 comprises a source terminal 722 associated with a voltage $V_S$, a drain terminal 724 associated with a voltage $V_D$, and a gate terminal 725 associated with a voltage $V_g$. pMOS transistors typically have negative threshold voltages (i.e. $V_T < 0$). A pMOS transistor can act as a short, or conduct, when $V_g - V_S < -|V_T|$ and act as an open circuit when $V_g - V_S > -|V_T|$. For pMOS transistors, $V_S$ can be large to ensure that $V_g - V_S$ conditions can more easily be satisfied. In addition, pMOS transistors can have $V_D < V_S$ such that current is sunk from the load to the source. By tuning the source and gate voltages of the pMOS transistor, a circuit can thus act as a short or open circuit. Some pMOS transistors can comprise an additional body terminal such that the pMOS transistor has four terminals.

FIG. 7C depicts a nMOS transistor *t*-gate 726 that can be used as each gate circuit of the plurality of gate circuits 702A-702N in the *t*-gate multiplexer circuit 700. In some implementations, a *t*-gate multiplexer circuit 700 with the nMOS transistor *t*-gate 726 as each gate circuit of the plurality of gate circuits 702A-702N can be connected to a *p*-dit with one-hot encoding. The nMOS transistor t-gate 726 comprises a source terminal 727 associated with a voltage $V_S$, a drain terminal 728 associated with a voltage $V_D$, and a gate terminal 729 associated with a voltage $V_g$. nMOS transistors typically have positive threshold voltages $V_T$. An nMOS transistor can act as a short, or conduct, when $V_g - V_S > V_T$ and act as open circuits when $V_g - V_S < V_T$. nMOS transistors can have $V_D > V_S$ and can source current to the load. The voltage $V_S$ can be low (near or at ground) to ensure the above conditions can easily be satisfied. Some nMOS transistors can also comprise an additional body terminal such that the nMOS transistor has four terminals.

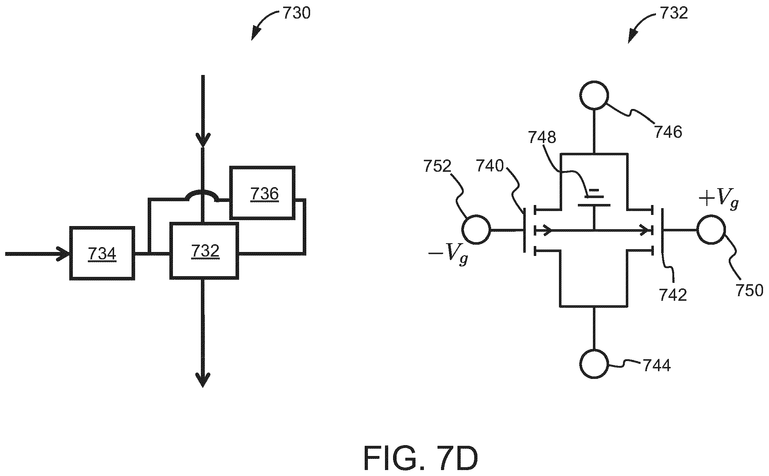

FIG. 7D depicts a circuit 730 that can be used as each gate circuit of the plurality of gate circuits 702A-702N in the *t*-gate multiplexer circuit 700. In some implementations, a *t*-gate multiplexer circuit 700 with the pMOS transistor *t*-gate 720 as each gate circuit of the plurality of gate circuits 702A-702N can be connected to a *p*-dit with one-cold encoding. The circuit 730 comprises a *t*-gate circuit 732, a first inverter 734, and a second inverter 736. The t-gate circuit 732 comprises a four-terminal pMOS transistor 740 and a four-terminal nMOS transistor 742 with source terminals connected at a node 744 and drain terminals connected at a node 746. The node 746 can receive a voltage distribution from a noise circuit. The body terminals of the four-terminal pMOS transistor 740 and the four-terminal nMOS transistor 742 are connected to a common ground 748. For the four-terminal nMOS transistor 742, $V_g$ can be applied to the gate terminal 750 while for the four-terminal pMOS transistor 740, $-V_g$ can be applied to the gate terminal 752. In the circuit 730, the output of the first inverter 734 is connected to the gate terminal 752 and the output of the second inverter 736 is connected to the gate terminal 750.

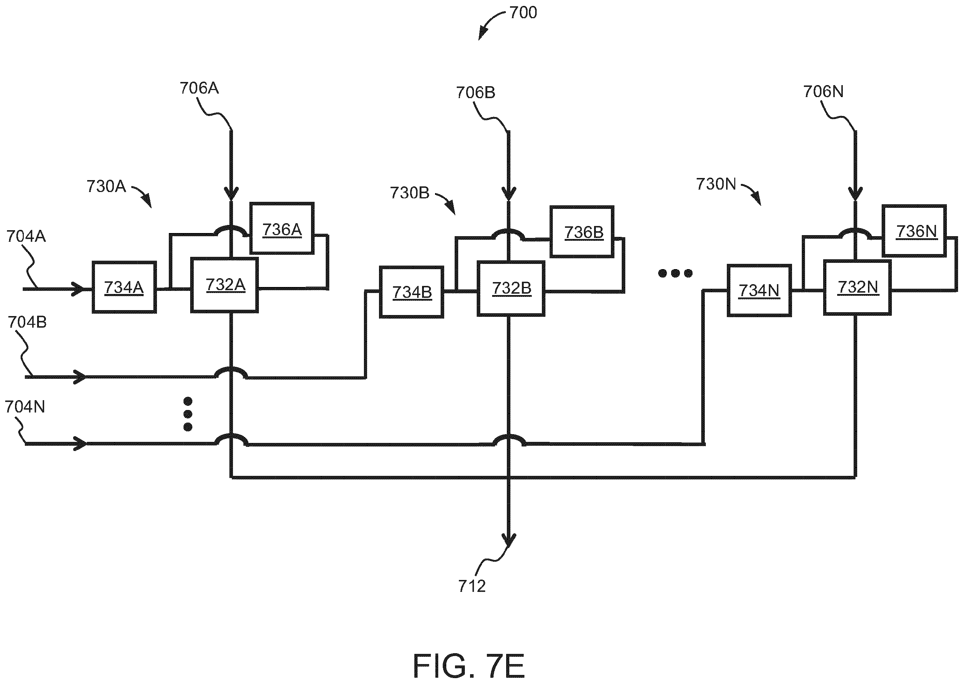

FIG. 7E depicts an example implementation of the t-gate multiplexer circuit 700 comprising a plurality of circuits 730A-730N, i.e., a circuit 730A, a circuit 730B, and a circuit 730N, as each gate circuit of the plurality of gate circuits 702A-702N. Each circuit of the plurality of circuits 730A-730N comprises a *t*-gate 732A-732N comprising a nMOS transistor and a pMOS as depicted in FIG. 7D, a first inverter of a plurality of first inverters 734A-734N, and a second inverter of a plurality of second inverters 736A-736N. In some implementations, each first inverter of the first plurality of inverters 734A-734N associated with a respective circuit 730A-730N can be positioned closer to a respective input node 704A-704N.

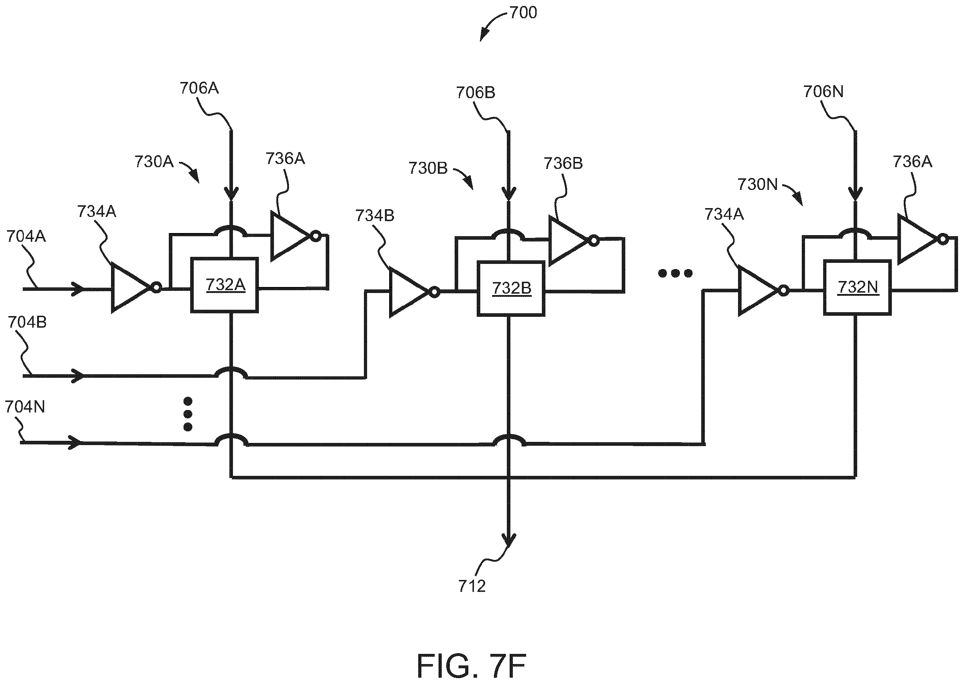

FIG. 7F depicts an example implementation of the *t*-gate multiplexer circuit 700 comprising a plurality of circuits 730A-730N as each gate circuit of the plurality of gate circuits 702A-702N. Each circuit 730A-730N comprises a *t*-gate 732A-732N comprising a nMOS transistor and a pMOS as depicted in FIG. 7D, a first inverter of a plurality of first inverters 734A-734N, and a second inverter of a plurality of second inverters 736A-736N. In some implementations, each first inverter of the plurality of first inverters 734A-734N associated with a respective circuit 730A-730N can be positioned closer to a respective input node 704A-704N.

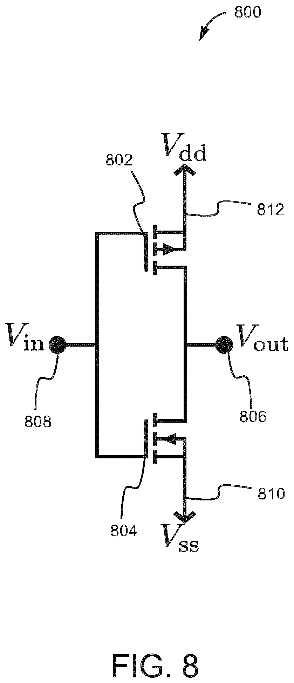

FIG. 8 depicts an example circuit 800 that can be utilized as any of the noise circuits 104A-104N in the circuit architecture 100 depicted in FIG. 1. The circuit 800 is an example of an inverter circuit. The circuit 800 comprises pMOS transistor 802 and nMOS transistor 804 which share a common drain terminal 806 and gate terminal 808. The device is powered by applying a voltage difference $V_{dd}$ - $V_{ss}$ between the source terminal 810 and the source terminal 812. When the input voltage $V_{in} < (V_{dd} + V_{ss})/2$, the nMOS transistor 804 becomes an open circuit and $V_{out}$ approaches $V_{dd}$. When $V_{in} > (V_{dd} + V_{ss})/2$, the opposite scenario happens and $V_{out}$ approaches $V_{ss}$.

Without intending to be bound by theory, the following is an example of a theoretical model for illustrating features. The nMOS transistor 804 and pMOS transistor 802 in circuit 800 can be modelled as an externally controlled conduction channel between source and drain, with associated Poisson rates $\lambda^n_\pm$ and $\lambda^p_\pm$. The gate-body interface has capacitor $C_g$, and another capacitor $C_o$ takes into account the output capacitance. The transition rates for the nMOS transistor are

$$\lambda^n_+(q) = (I_0/q_e)e^{(V_{in} - V_{ss} - V_{th})/(nV_T)} \tag{2}$$

$$\lambda^n_-(q) = \lambda^n_+(q)e^{-[(q+q_e/2)/(2C_o)+\Delta V/2]/V_T} \tag{3}$$

where $\Delta V = V_{dd}$ - $V_{ss}$. For the pMOS transistor the transition rates are

$$\lambda^p_+(q) = (I_0/q_e)e^{(V_{dd} - V_{in} - V_{th})/(nV_T)} \tag{4}$$

$$\lambda^p_-(q) = \lambda^p_+(q)e^{-[-(q-q_e/2)/(2C_o)+\Delta V/2]/V_T} . \tag{5}$$

The master equation for the distribution $P(q,t)$ can then given by

$$\frac{dP(q,t)}{dt} = P(q-q_e,t)[\lambda^n_-(q-q_e) + \lambda^p_+(q-q_e)] + P(q+q_e,t)[\lambda^n_+(q+q_e) + \lambda^p_-(q+q_e)]$$
$$- P(q,t)[\lambda^n_-(q) + \lambda^n_+(q) + \lambda^p_-(q) + \lambda^p_+(q)], \tag{6}$$

which can used to find the steady state of the output node given the voltages $V_{in}$, $V_{dd}$ and $V_{ss}$. Solving eq. (6), a probability distribution describing the voltage at the output mode is at equilibrium when $V_{dd} = -V_{ss} = 0$ and for practical purposes can be Gaussian. In other words, the distribution is a continuous distribution over a range of voltages and the continuous distribution is substantially Gaussian. When a bias is applied without an input voltage, i.e. $V_{dd} = -V_{ss} = 5V_T$, the probability distribution becomes stretched and ceases to be Gaussian. Further, if a small input voltage is applied (say $V_{in}/V_{dd} = -0.01$), the probability distribution is tilted to one side. A further increase of the input voltage (say $V_{in}/V_{dd} = -0.2$) generates an approximately Gaussian peak centered around the value corresponding to the deterministic solution.

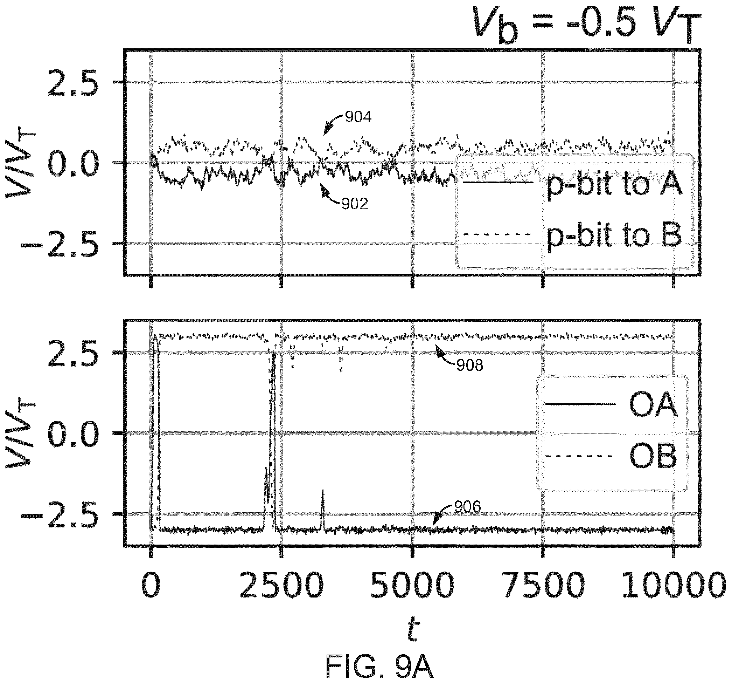

FIG. 9A depicts a plot of numerical simulations associated with a pdemux circuit. Referring back to FIG. 2B, the pdemux circuit is a circuit module 230 with a metastable circuit as the circuit 240 and AND gates as the first logical circuit 242 and the second logical circuit 244. FIG. 9A depicts the voltage of nodes associated with a pdemux circuit over time at a bias voltage $V_b = -0.5V_T$. The voltage 902 corresponds to an output of the metastable circuit connected to the first logical circuit 242 over time. The voltage 904 corresponds to the output of the metastable circuit connected to the second logical circuit 244 over time. The voltage 906 is the voltage at the first output node 236 over time and the voltage 908 is the voltage at the second output node 238 over time. The voltage 906 and the voltage 908 depend on the voltage 902 and the voltage 904 associated with the metastable circuit, with a slight delay in time.

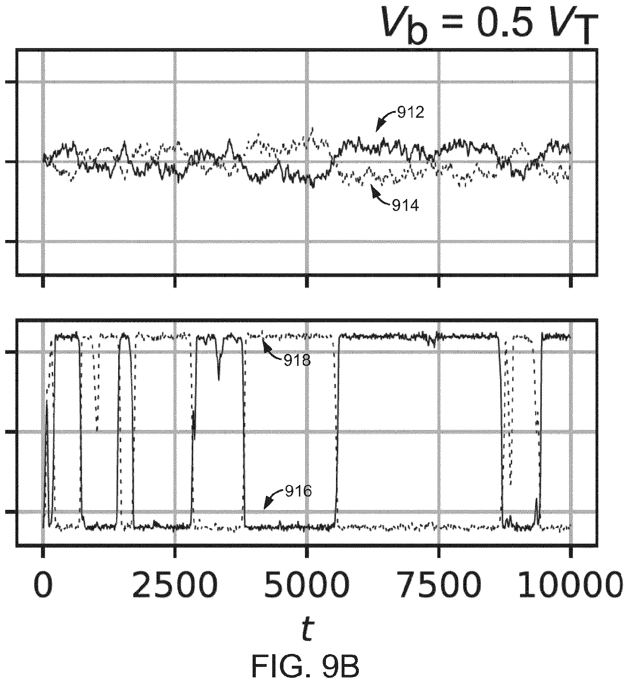

FIG. 9B depicts a plot of numerical simulations associated with a pdemux circuit. Referring back to FIG. 2B, the pdemux circuit is a circuit module 230 with a metastable circuit as the circuit 240 and AND gates as the first logical circuit 242 and the second logical circuit 244. FIG. 9B depicts the voltage of nodes associated with a pdemux circuit over time at a bias voltage $V_b = 0.5V_T$. The voltage 912 corresponds to an output of the metastable circuit connected to the first logical circuit 242 over time. The voltage 914 corresponds to the output of the metastable circuit connected to the second logical circuit 244 over time. The voltage 916 is the voltage at the first output node 236 over time and the voltage 918 is the voltage at the second output node 238 over time. The voltage 916 and the voltage 918 depend on the voltage 912 and the voltage 914 associated with the metastable circuit, with a slight delay in time.

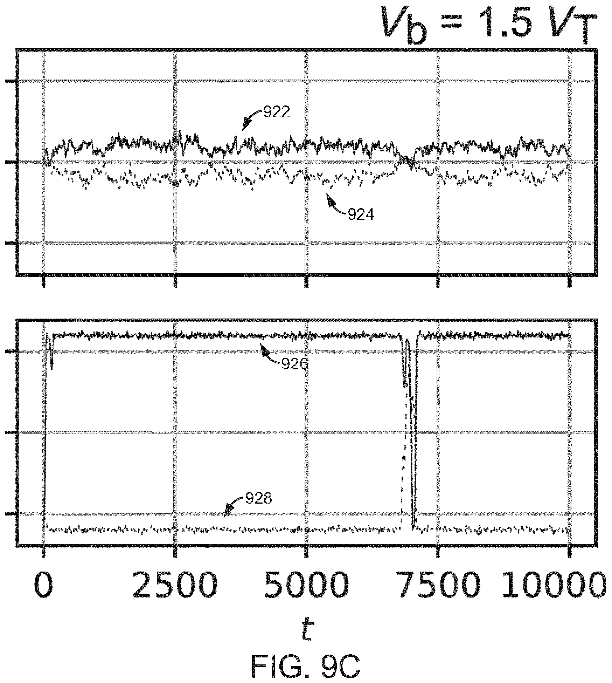

FIG. 9C depicts a plot of numerical simulations associated with a pdemux circuit. Referring back to FIG. 2B, the pdemux circuit is a circuit module 230 with a metastable circuit as the circuit 240 and AND gates as the first logical circuit 242 and the second logical circuit 244. FIG. 9C depicts the voltage of nodes associated with a pdemux circuit over time at a bias voltage $V_b = 1.5V_T$. The voltage 922 corresponds to an output of the metastable circuit connected to the first logical circuit 242 over time. The voltage 924 corresponds to the output of the metastable circuit connected to the second logical circuit 244 over time. The voltage 926 is the voltage at the first output node 236 over time and the voltage 928 is the voltage at the second output node 238 over time. The voltage 926 and the voltage 928 depend on the voltage 922 and the voltage 924 associated with the metastable circuit, with a slight delay in time.

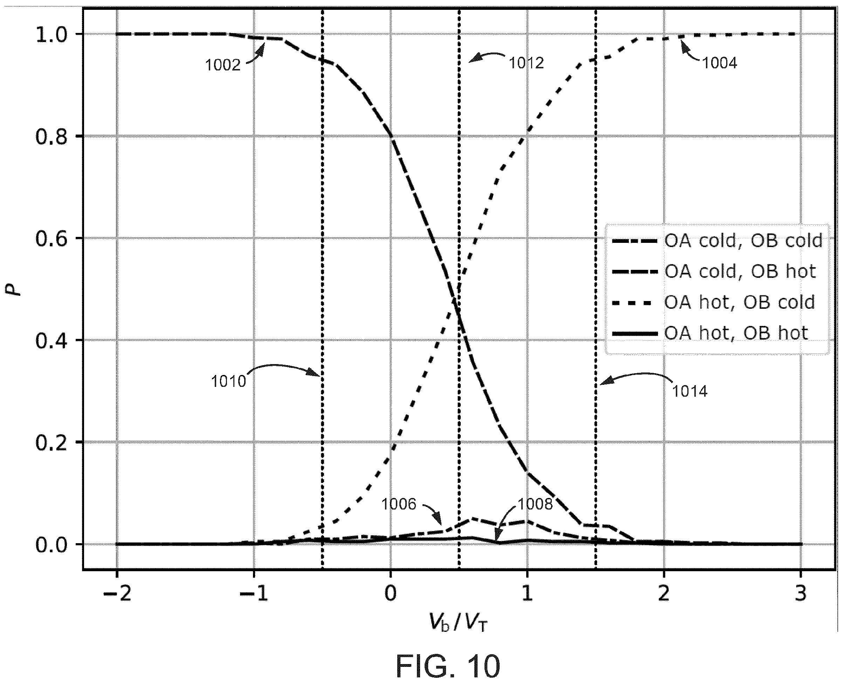

FIG. 10 depicts a plot of numerical simulations associated with a pdemux circuit. Referring back to FIG. 2B, the pdemux circuit is a circuit module 230 with a metastable circuit as the circuit 240 and AND gates as the first logical circuit 242 and the second logical circuit 244. The probabilities of each of the possible logical states (one or zero) at each of the first output node 236 and the second output node 238 of a pdemux circuit are plotted as a function of the biasing voltage $V_b$ as a function of the thermal voltage $V_T$. The plot in FIG. 10 depicts the probability 1002 of the first output node 236 being cold or zero while the second output node 238 is hot or one. Further, the plot in FIG. 10 depicts the probability 1004 of the first output node 236 being hot or one while the second output node 238 is cold or zero. The plot in FIG. 10 also depicts the probability 1006 of the first output node 236 and the second output node 238 both being cold or zero and the probability 1008 of the first output node 236 and the second output node 238 both being hot or one. The dashed line 1010 corresponds to a bias voltage $V_b = -0.5V_T$, the dashed line 1012 corresponds to a bias voltage $V_b = 0.5V_T$, and the dashed line 1014 corresponds to a bias voltage $V_b = 1.5V_T$.

The following parameters were utilized to generate the plots depicted in FIGS. 9A-9C and FIG. 10. In some examples or implementations, other parameters can be utilized to generate plots or to construct and operate associated devices. The thermal voltage is $V_T = 26mV$. Each transistor has a capacitance of 100 aF between a gate terminal and a source terminal, and also between a drain and a source terminal. Each of the first output node 236 and the second output node 238 has 2 fF of additional capacitance to ground added. Each transistor has a subthreshold slope of $n = 1$. Each transistor has the same speed $I_0 e^{-V_{th}}$, where $I_0$ is the specific current and $V_{th}$ is the threshold voltage, except for the two transistors in the associated with the metastable circuit's biasing circuit, which are assumed to be ten times slower. The timescales against which the plots depicted in FIGS. 9A-9C are plotted are "dimensionless times" measured with respect to a characteristic timescale of transistors. The "dimensionless time" can be written as $t I_0 e^{-V_{th}}$, where t is the physical time. The top and bottom rails powering the AND gates in the pdemux circuit are $3V_T$ and $-3V_T$, respectively. The top and bottom rails associated with powering the metastable circuit in the pdemux circuit are $0.78V_T$ and $-0.78V_T$, respectively. The input voltage is $3V_T$. The powering voltage for the biasing circuit associated with a metastable circuit is $V_T$.

In some implementations, a circuit architecture can be formed as part of a system. A system can be implemented in various configurations, including as a single apparatus or as a combination of one or more apparatuses that collectively perform the functions of a system. In some examples, the one or more apparatuses can form a device, i.e., a system-on-a-chip, or the one or more apparatuses can be separate devices.

In some implementations, a system can be formed from one or more integrated circuit (IC) chips comprising portions of a circuit architecture. Some circuit architectures can be distributed across multiple chips or consolidated onto a single chip. Some chips can comprise multiple layers of material. In some examples, portions of a circuit architecture can be formed across several layers of devices.

Some systems can comprise analog, digital, or mixed-signal circuitry configured to perform functions such as signal processing, voltage regulation, or data acquisition. Some systems can comprise interface or control circuitry configured to perform functions such as applying bias voltages, measuring voltages, or interfacing with components of the circuit. In some examples, control circuitry can be implemented in one or more dedicated regions of an IC, or distributed throughout a circuit architecture. In some examples, control circuitry can comprise components such as a field-programmable gate array (FPGA), an application specific integrated circuit (ASIC), one or more processors or processor cores, including central processing unit(s) (CPU(s)) and/or graphics processing unit(s) (GPU(s)), or other computing devices or modules capable of executing a program (e.g., software and/or firmware) comprising instructions or other compiled or executable code. The electronic circuitry can also include at least one data storage system (e.g., including volatile and non-volatile memory, and/or storage media). The program may be provided on a computer-readable storage medium, or delivered over a communication medium such as a wired or wireless network, to a device module where it can be stored and eventually executed when read by the device to perform the procedures of the program.

In some implementations, portions of a circuit architecture and control circuitry can be arranged in a flip-chip configuration to allow for three-dimensional integration of multiple chips or substrates. Some flip-chip configurations comprise conductive structure such as wire bonds, microbumps, or vias to facilitate electrical communication between multiple layers or chips.

While the disclosure has been described in connection with certain embodiments, it is to be understood that the disclosure is not to be limited to the disclosed embodiments but, on the contrary, is intended to cover various modifications and equivalent arrangements included within the scope of the appended claims, which scope is to be accorded the broadest interpretation so as to encompass all such modifications and equivalent structures as is permitted under the law.

**Claims**

1. An apparatus comprising:

   a plurality of circuit modules, each circuit module of the plurality of circuit modules having a first input node, a second input node, a first output node, and a second output node, and comprising

   a metastable circuit configured to receive a bias voltage from the first input node and produce a bistable state based at least in part on the bias voltage;
   a first logical circuit configured to receive a signal based at least in part on the bistable state and a voltage from the second input node and output a logical combination of the signal based at least in part on the bistable state and the voltage from the second input node to the first output node; and
   a second logical circuit configured to receive a signal based at least in part on the bistable state and a voltage from the second input node and output a logical combination of the signal based at least in part on the bistable state and the voltage from the second input node to the second output node;

   wherein the second input node of a first circuit module of the plurality of circuit modules is connected to a voltage source, and the first output node and the second output node of the first circuit module of the plurality of circuit modules are each connected to a different respective second input node of another circuit module of the plurality of circuit modules.

2. The apparatus of claim 1, wherein the second input nodes of each other circuit module of the plurality of circuit modules not including the first circuit module of the plurality of circuit modules are connected to a different respective output node of a circuit module of the plurality of circuit modules.

3. The apparatus of claim 1, wherein each circuit module of the plurality of circuit modules having the first output node connected to a circuit module of the plurality of circuit modules has the second output node connected a different respective circuit module of the plurality of circuit modules.

4. The apparatus of claim 1, 2 or 3, wherein each of the first logical circuit and the second logical circuit in each circuit module of the plurality of circuit modules comprises a NAND gate.

5. The apparatus of claim 4, wherein each of the first logical circuit and the second logical circuit in each circuit module of the plurality of circuit modules that does not have a first output and a second output connected to respective circuit modules of the plurality of circuit modules comprises an AND gate.

6. The apparatus of any one of claims 1 to 5, wherein each of the first logical circuit and the second logical circuit in each circuit module of the plurality of circuit modules that does not have a first output and a second output connected to respective circuit modules of the plurality of circuit modules comprise an AND gate.

7. An apparatus comprising:

   a metastable circuit module including more than two output nodes, wherein
   the more than two output nodes are associated with a bistable state that varies over time between a first stable voltage and a second stable voltage, where a fraction of time that the bistable state spends at the first stable voltage is associated with a probability;
   a plurality of noise circuits, where each noise circuit of the plurality of noise circuits is configured to produce a voltage distribution; and
   a mixer circuit comprising more than two gate circuits, where each gate circuit of the more than two gate circuits is connected to a respective output node of the metastable circuit module and to a respective noise circuit;

wherein the mixer circuit is configured to produce a voltage distribution that is based at least in part on each probability associated with the metastable circuit module and each voltage distribution associated with a respective noise circuit of the plurality of noise circuits.

8. The apparatus of claim 7, wherein each gate circuit of the more than two gate circuits of the mixer circuit comprises one or both of a p-type metal-oxide-semiconductor transistor, or an n-type metal-oxide-semiconductor transistor.

9. The apparatus of claim 7 or 8, wherein each gate circuit of the more than two gate circuits of the mixer circuit comprises

> a first inverter circuit,
> a second inverter circuit,
> a first transistor having a first body terminal, a first gate terminal, a first source terminal, and a first drain terminal, and
> a second transistor having a second body terminal, a second gate terminal, a second source terminal, and a second drain terminal.

10. The apparatus of claim 9, wherein

> the first body terminal and the second body terminal are connected to a common ground,
> the first drain terminal and the second drain terminal are connected to a first node that receives a voltage distribution from a respective noise circuit,
> an output of the first inverter circuit is connected to the first gate terminal at a second node,
> the second inverter circuit is connected to the second node,
> an output of the second inverter circuit is connected to the second gate terminal, and
> the first source terminal and the second source terminal are connected to a third node.

11. The apparatus of claim 9 or 10, wherein the first transistor is a p-type metal-oxide-semiconductor transistor and the second transistor is an n-type metal-oxide-semiconductor transistor.

12. The apparatus of any one of claims 7 to 11, wherein each noise circuit of the plurality of noise circuits is configured to produce a voltage distribution that is substantially Gaussian.

13. The apparatus of any one of claims 7 to 12, wherein the metastable circuit module comprises a plurality of circuit modules and each circuit module of the plurality of circuit modules is connected to a respective output node of the metastable circuit module.

14. The apparatus of any one of claims 1 to 13, wherein each circuit module of the plurality of circuit modules comprises a metastable circuit configured to receive a bias voltage and produce a bistable state based at least in part on the bias voltage, where the bistable state varies over time between a first stable voltage and a second stable voltage and a fraction of time that the bistable state spends at the first stable voltage is associated with a first probability.

15. The apparatus of any one of claims 1 to 14, wherein each circuit module of the plurality of circuit modules further comprises a level-shifter circuit that is configured to add a reference voltage to or subtract a reference voltage from each of the third stable voltage and the fourth stable voltage.

FIG. 1

FIG. 2A

FIG. 2C

FIG. 2B

FIG. 3A

FIG. 3B

EP 4 687 289 A1

300C

$V_{dd}$   $V_{dd}$

326

322

$V_b$

324

$V_{in}$

330

332

328

$-V_{dd}$   $-V_{dd}$

FIG. 3C

EP 4 687 289 A1

300D

360

352

$V_b^p$

$V_{in}^p$

356

$V_{in}^n$

$V_{out}^1$

$V_{out}^2$

354

$V_b^n$

358

Noise generator

Single-ended to diff converter

P-Level shifter

N-Level shifter

362

FIG. 3D

FIG. 4A

FIG. 4B

+1 →

504A

504B

504C

504D

504E

504F

504G

0    0      0    0      1    0      0    0

FIG. 5A

FIG. 5B

EP 4 687 289 A1

520

524A

$p_1$   $1 - p_1$

524B

524C

$p_2$   $1 - p_2$     $p_3$   $1 - p_3$

524D

524E

524F

524G

$p_4$   $1 - p_4$    $p_5$   $1 - p_5$    $p_6$   $1 - p_6$    $p_7$   $1 - p_7$

FIG. 5C

EP 4 687 289 A1

FIG. 6

FIG. 7A

FIG. 7C

FIG. 7B

FIG. 7D

FIG. 7E

FIG. 7F

EP 4 687 289 A1

FIG. 8

EP 4 687 289 A1

$V_b = -0.5\ V_T$

FIG. 9A

FIG. 9B

EP 4 687 289 A1

FIG. 9C

FIG. 10

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/294944 A1 (KUENEMUND THOMAS [DE] ET AL) 15 October 2015 (2015-10-15) * paragraph [0081] - paragraph [0082]; figures 3-8,13-17,22 * * paragraph [0105] - paragraph [0136] * * paragraph [0246] * ----- | 1-9, 12-15 | INV. H03K3/037 H03K19/094 G06F7/58 |
| X | JP 3 149771 B2 (NEC CORP) 26 March 2001 (2001-03-26) * figures 1-6 * ----- | 1,3,7,8, 10-12, 14,15 | |

TECHNICAL FIELDS
SEARCHED    (IPC)

H03K
G06F

The present search report has been drawn up for all claims

| Place of search | Date of completion of the search | Examiner |
|---|---|---|
| Munich | 9 December 2025 | Mesplede, Delphine |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 19 0661

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2025

| Patent document cited in search report | Publication date | Patent family member(s) | Publication date |
|---|---|---|---|
| US 2015294944 A1 | 15-10-2015 | CN 104978499 A<br>DE 102015105417 A1<br>US 2015294944 A1 | 14-10-2015<br>15-10-2015<br>15-10-2015 |
| JP 3149771 B2 | 26-03-2001 | JP 3149771 B2<br>JP H09214298 A | 26-03-2001<br>15-08-1997 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63677528